# EUROPEAN PATENT APPLICATION

(11) **EP 1 477 588 A1**
(43) Date of publication of application: **17.11.2004**
(21) Application number: 04250637.8
(22) Date of filing: 06.02.2004
(51) Int. Cl.: C25D 3/38, H01L 21/288, H05K 3/42

(54) **Copper Electroplating composition for wafers**

(30) Priority: 19.02.2003 US 447411 P; 27.02.2003 US 450283 P
(71) Applicant: Rohm and Haas Electronic Materials, L.L.C., Marlborough, Massachusetts 01752 (US)
(72) Inventor: Wang, Deyan, Hudson, Massachusetts 01749 (US); Mikkola, Robert D., Grafton, Massachusetts 01536 (US); Binstead, Robert A., Marlborough, Massachusetts 01752 (US)
(74) Representative: Kent, Venetia Katherine

(57) **Abstract**

Compositions useful for electrodepositing a metal are provided. These compositions contain one or more metal salts, electrolyte, two or more brightener compounds and optionally one or more of leveler compounds and wetting agents. Also provided are methods of depositing a metal layer using these compositions.

## Description

### Background of the Invention

The present invention relates generally to the field of electroplating. In particular, the present invention relates to the field of electrodeposition of copper on substrates.

Methods for electroplating articles with metal coatings generally involve passing a current between two electrodes in a plating solution where one of the electrodes is the article to be plated. A typical acid copper plating solution comprises dissolved copper (usually copper sulfate), an acid electrolyte such as sulfuric acid in an amount sufficient to impart conductivity to the bath, and proprietary organic additives to improve the uniformity of the plating and the quality of the metal deposit. Such additives include brighteners, levelers, surfactants, suppressors, and the like.

Electrolytic copper plating solutions are used for many industrial applications. For example, they are used in the automotive industry to deposit base layers for subsequently applied decorative and corrosion protective coatings. They are also used in the electronics industry, particularly for the fabrication of printed circuit boards and semiconductors. For circuit board fabrication, copper is electroplated over selected portions of the surface of a printed circuit board and onto the walls of through holes passing between the surfaces of the circuit board base material, and to fill vias passing from one surface of the printed circuit board in an interior layer of the board. The walls of a through hole or via are first metallized to provide conductivity between the board's circuit layers. For semiconductor fabrication, copper is electroplated over the surface of a wafer containing a variety of features such as vias, trenches or a combination thereof. The vias and trenches are metallized to provide conductivity between various layers of the semiconductor device.

Plating a substrate having irregular topography can pose particular difficulties. During electroplating a voltage drop variation typically will exist along an irregular surface which can result in an uneven metal deposit. Plating irregularities are exacerbated where the voltage drop variation is relatively extreme, i.e., where the surface irregularity is substantial. As a result, a thicker metal deposit, termed overplating, is observed over such surface irregularities. Consequently, high quality metal plating (e.g., a metal layer or plate of substantially uniform thickness) is frequently a challenging step in the manufacture of electronic devices.

It is known in certain areas of plating that the use of brighteners and/or levelers in the electroplating bath can be crucial in achieving a uniform metal deposit on a substrate surface. Conventional copper plating baths typically contain bis-(sodium sulfopropyl)-disulfide as a brightener. This compound is generally considered the best in its class for super-conformal filling of sub-micron vias and trenches in the manufacture of electronic devices. However, as feature sizes have shrunk, there is a concern that such brighteners lead to increased surface roughness during the initial plating stages (ca. ≤ 1000 - 2000 Å of deposit). Such surface roughness can result in micro-void formation during the plating of sub-micron sized features such as trenches and vias.

Leveling agents are typically in copper plating baths to provide substantially uniform, or level, copper layers. Such leveling agents have been proposed in copper plating baths used to deposit copper in apertures during integrated circuit manufacture. For example, U.S. Patent No. 6,444,110 (Barstad et al.) discloses a method of depositing copper in apertures during integrated circuit manufacture by electroplating copper from a copper plating bath containing at least one soluble copper salt, an electrolyte, one or more brightener compounds having a molecular weight of 1000 or less and being present in a concentration of at least about 1.5 mg/L, and preferably one or more leveling agents. The use of leveling agents in copper plating baths used for semiconductor manufacture is known to provide poor fill performance of small apertures, such as vias and trenches. For example, leveling agents that have been used in semiconductor manufacture form substantially planar surfaces, however, they also form a substantial number of voids in the vias or trenches. Such voids can cause electrical open circuits in the semiconductor. As the geometries of electronic devices get smaller, the difficulty of plating a uniform copper layer while completely filling the smaller features becomes more difficult.

There is a need in the art for copper plating baths that do not form voids, show reduced surface roughness and are useful for plating substrates having different sized features. Such copper plating baths would be particularly useful in printed circuit board manufacture and in integrated circuit manufacture.

### Summary of the Invention

The present invention provides a composition including one or more sources of metal ions, an electrolyte, and two or more brightening agents, wherein at least one brightening agent is an organosulfonic acid compound and at least one brightening agent is a dithiocarbonate-containing compound.

Also provided by the present invention is a method of manufacturing an electronic device including the step of depositing a layer of metal on the substrate by contacting the substrate with the composition described above and applying sufficient current density for a period of time to deposit the layer of metal.

In particular, the present invention provides a method of manufacturing an integrated circuit including one or more apertures having a size of ≤ 2 µm, including the step of contacting a substrate with the composition described above and applying sufficient current density for a period of time sufficient to deposit a layer of metal.

A method of depositing a metal layer on a substrate comprising the steps of contacting the substrate with the composition of claim 1 and applying sufficient current density for a period of time to deposit the layer of metal is further provided.

### Brief Description of the Drawing

Fig. 1 is an atomic force micrograph ("AFM") of a 1000 Å thick copper layer deposited using a conventional copper plating bath.
Fig. 2 is an AFM of a 1000 Å thick copper layer deposited using a copper plating bath of the invention.
Figs. 3A and 3B are scanning electron micrographs ("SEMs") of a cross-section of a 0.5 µm trench on a wafer plated with a 500 Å and 1000 Å , respectively, thick copper layer using a conventional copper plating bath.
Figs. 4A and 4B are SEMs of a cross-section of a 0.5 µm trench on a wafer plated with a 500 Å and 1000 Å, respectively, thick copper layer using a copper plating bath of the invention.

### Detailed Description of the Invention

As used throughout this specification, the following abbreviations shall have the following meanings, unless the context clearly indicates otherwise: A = amperes; mA/cm² = milliamperes per square centimeter; °C = degrees Centigrade; g = gram; mg = milligram; Å = angstrom; L = liter, ppm = parts per million; ppb = parts per billion; µm = micron = micrometer; cm = centimeter; RPM = revolutions per minute; DI = deionized; and mL = milliliter. All amounts are percent by weight and all ratios are by weight, unless otherwise noted. All numerical ranges are inclusive and combinable in any order, except where it is clear that such numerical ranges are constrained to add up to 100%.

As used throughout the specification, "feature" refers to the geometries on a substrate, such as, but not limited to, trenches and vias. "Apertures" refer to recessed features, such as vias and trenches. The term "small features" refers to features that are one micron or smaller in size. "Very small features" refers to features that are one-half micron or smaller in size. Likewise, "small apertures" refer to apertures that are one micron or smaller (≤ 1 µm) in size and "very small apertures" refer to apertures that are one-half micron or smaller (≤ 0.5 µm) in size. As used throughout this specification, the term "plating" refers to metal electroplating, unless the context clearly indicates otherwise. "Deposition" and "plating" are used interchangeably throughout this specification. "Halide" refers to fluoride, chloride, bromide and iodide. Likewise, "halo" refers to fluoro, chloro, bromo and iodo. The term "alkyl" includes linear, branched and cyclic alkyl. "Brightener" refers to an organic additive that increases the plating rate of the electroplating bath. The terms "brightener," brightening agent" and "accelerator" are used interchangeably throughout this specification. "Suppressors", which are also known as "carriers", refer to organic additives that suppresses the plating rate of a metal during electroplating. "Leveler" refers to an organic compound that is capable of providing a substantially planar metal layer. The terms "levelers" and "leveling agents" are used interchangeably throughout this specification.

The present invention provides a composition including one or more sources of metal ions, an electrolyte, and two or more brightening agents, wherein at least one brightening agent is an organosulfonic acid compound and at least one brightening agent is a dithiocarbonate-containing compound. Such composition is suitable for electroplating a layer of metal, particularly copper, on a conductive substrate.

Any substrate upon which a metal, particularly copper, can be electroplated is useful in the present invention. Such substrates include, but are not limited to, printed wiring boards, integrated circuits, semiconductor packages, lead frames, interconnects, and the like. Particularly useful substrates are any used in the manufacture of electronic devices, such as integrated circuits, and more particularly wafers used in dual damascene manufacturing processes. Such substrates typically contain a number of features, particularly apertures, having a variety of sizes. For example, integrated circuit substrates may contain apertures ranging from 100 µm to as little as 50 nm or 25 nm or less. In one embodiment, it is preferred that the substrate contains small apertures, and preferably very small apertures. Such small apertures may be present in the substrate along with larger apertures, such as 100 µm apertures. For example, an integrated circuit substrate may contain one or more 0.2 µm as well as one or more 2 µm, or even larger, apertures. It is further preferred that the apertures that are filled by copper deposited from the instant plating baths are free of voids. It will be appreciated by those skilled in the art that other substrates to be plated, such as lead frames and printed wiring boards, may have larger features or smaller features or no features at all. The present invention is particularly suitable for filling apertures of varying aspect ratios, such as low aspect ratio apertures and high aspect ratio apertures. By "low aspect ratio" is meant an aspect ratio of from 0.1:1 to 4:1. The term "high aspect ratio" refers to aspect ratios of 4:1 or greater such as 10:1 1 or 20:1. Thus, apertures having a wide variety of aspect ratios, such as 0.5:1, 1:1, 2:1, 2.5:1, 3:1, 4:1, 5:1, 6:1, 8:1, 10:1 or even higher, may be plated with copper according to the present invention. In one embodiment, the present compositions are useful for filling both high and low-aspect ratio apertures on a substrate.

Any metal ion source that is at least partially soluble in the electroplating bath and which metal can be deposited electrolytically is suitable for use in the present invention. It is preferred that the metal ion source is soluble in the plating bath. Suitable metal ion sources are metal salts and include, but are not limited to, metal sulfates, metal halides, metal acetates, metal nitrates, metal fluoroborates, metal alkylsulfonates, metal arylsulfonates, metal sulfamates, metal gluconates and the like. Suitable metal salts include, but are not limited to, tin salts, copper salts, silver salts, bismuth salts and the like. Copper is a particularly suitable metal. Typical sources of copper ions include, without limitation, copper sulfate, copper chloride, copper acetate, copper nitrate, copper fluoroborate, copper methane sulfonate, copper phenyl sulfonate and copper p-toluene sulfonate. Copper sulfate pentahydrate is particularly suitable. Such metal salts are generally commercially available and may be used without further purification.

The metal salts may be used in the present invention in any amount that provides sufficient metal ions for electroplating on a substrate. When the metal is copper, the copper salt is typically present in an amount sufficient to provide an amount of copper metal of 10 to 80 g/L of plating solution. It will be appreciated that mixtures of sources of metal ions may be used in the present invention. Thus, alloys, such as copper-tin having up to 2 percent by weight tin, may be advantageously plated according to the present invention. Other suitable copper alloys include, but are not limited to copper-silver, tin-copper-silver, tin-copper-bismuth, and the like. The amounts of each of the sources of metal ions in such mixtures depends upon the particular alloy to be plated and is well known to those skilled in the art. Typically, the amount of such alloying metal ion is up to 5% by weight of the total amount of metal ions in the composition.

The present metal electroplating baths include an electrolyte, typically an acidic electrolyte. Such baths are typically aqueous. Suitable acidic electrolytes include, but are not limited to, sulfuric acid, acetic acid, fluoroboric acid, alkylsulfonic acids such as methanesulfonic acid, ethanesulfonic acid, propanesulfonic acid and trifluoromethane sulfonic acid, arylsulfonic acids such as phenyl sulfonic acid, phenol sulfonic acid and toluenesulfonic acid, sulfamic acid, hydrochloric acid, phosphoric acid and the like. Mixtures of acids may be advantageously used in the present metal plating baths. Typically suitable acids include sulfonic acid, methanesulfonic acid, ethanesulfonic acid, propanesulfonic acid, and mixtures thereof. Such electrolytes are generally commercially available from a variety of sources and may be used without further purification. The acids are typically present in an amount in the range of from 1 to 300 g/L, preferably from 5 to 250 g/L, and more preferably from 10 to 180 g/L.

For certain applications, such as in the plating of wafers having very small apertures, it may be desired that the total amount of added acid be low. By "low acid" is meant that the total amount of added acid in the electrolyte is less than or equal to 20 g/L, and typically less than or equal to 10 g/L.

Such electrolytes may optionally contain a source of halide ions, such as chloride ions such as copper chloride or hydrochloric acid. A wide range of halide ion concentrations may be used in the present invention. Typically, the halide ion concentration is in the range of from 0 to 100 ppm based on the plating bath, and typically from 10 to 75 ppm. A particularly useful amount of halide ion is 20 to 75 ppm and more particularly 20 to 50 ppm. Such halide ion sources are generally commercially available and may be used without further purification.

Two or more brightening agents are used in the present compositions, wherein at least one brightening agent is an organosulfonic acid compound and at least one brightening agent is a dithiocarbonate-containing compound. Any organosulfonic acid may be used as the first brightening agent. As used herein, the term "organosulfonic acid" includes salts thereof. Suitable organosulfonic acids are those compounds having the formula R-SO₃X, where R is optionally substituted alkyl, optionally substituted heteroalkyl, optionally substituted aryl, or optionally substituted heterocyclic and X is hydrogen or a counter ion such as sodium, potassium or ammonium. Typically, the alkyl groups are (C₁-C₁₆)alkyl and more typically (C₃-C₁₂)alkyl. Heteroalkyl groups typically have one or more heteroatoms, such as nitrogen, sulfur or oxygen, in the alkyl chain. Suitable aryl groups include, but are not limited to, phenyl, benzyl, biphenyl and naphthyl. Suitable heterocyclic groups typically contain from 1 to 3 heteroatoms, such as nitrogen, sulfur or oxygen, and 1 to 3 separate or fused ring systems. Such heterocyclic groups may be aromatic or non-aromatic. Particularly useful organosulfonic acid compounds are those further containing a thiol or disulfide moiety. Specific organosulfonic acid brighteners suitable for use in the present invention include, but are not limited to, 3-mercapto-propylsulfonic acid-(3-sulfopropyl)ester; 3-mercapto-propylsulfonic acid sodium salt; carbonic acid-dithio-o-ethylester-s-ester with 3-mercapto-1-propane sulfonic acid potassium salt; bis-sulfopropyl disulfide; 3-(benzothiazolyl-s-thio)propyl sulfonic acid sodium salt; pyridinium propyl sulfobetaine; 1-sodium-3-mercaptopropane-1-sulfonate; 3-mercapto-ethyl propylsulfonic acid-(3-sulfoethyl)ester; 3-mercapto-ethylsulfonic acid sodium salt; bis-sulfoethyl disulfide; 3-(benzothiazolyl-s-thio)ethyl sulfonic acid sodium salt; pyridinium ethyl sulfobetaine; 1-sodium-3-mercaptoethane-1-sulfonate; N,N-dimethyl-dithiocarbamic acid-(3-sulfopropyl)ester; N,N-dimethyl-dithiocarbamic acid-(3-sulfoethyl)ester; and the like. Mixtures of organosulfonic acid brightening agents may be used.

Any dithicarbonate-containing compound may be used as the second brightening agent. In one embodiment, the dithiocarbonate-containing compound further contains one or more sulfonic acid or sulfonic acid ester moieties. Suitable dithiocarbonate-containing compounds are those having the formula R¹-S-C(=S)-O-R², where R¹ and R² are independently optionally substituted alkyl, optionally substituted heteroalkyl, optionally substituted aryl, or optionally substituted heterocyclic. Typically, the alkyl groups are (C₁-C₁₆)alkyl and more typically (C₁-C₆)alkyl. Suitable heteroalkyl, aryl and heterocyclic moieties are those described above. Exemplary dithiocarbonate-containing compounds include, without limitation, (O-ethyldithiocarbonato)-S-(3-sulfopropyl)-ester potassium salt, (O-ethyldithiocarbonato)-S-(3-sulfopropyl)-ester sodium salt, (O-ethyldithiocarbonato)-S-(3-propanesulfonic acid)-ester, and the like. Mixtures of dithiocarbonate-containing brightening agents may be used.

Both the first and second brightening agents are generally commercially available and may be used without further purification. The first organosulfonic acid brightening agent and the second dithiocarbonate-containing compound brightening agent may be used in a wide range of amounts, such as any suitable weight ratio such as from 99:1 to 1:99. Typically, the weight ratio of the first organosulfonic acid brightening agent and the second dithiocarbonate-containing compound brightening agent is ≥3:1, more typically ≥4:1, and even more typically ≥ 5:1. Even higher weight ratios of organosulfonic acid brightening agent to dithiocarbonate-containing compound brightening agent provide deposits having greatly reduced void formation in small or very small apertures compared to copper deposits from conventional electroplating baths. Suitable higher ratios are from 25:1 to 150:1, and more typically from 40:1 to 125:1, and still more typically from 50:1 to 100:1. In one embodiment, particularly suitable ranges are from 20:1 to 1:20 and more typically from 10:1 to 1:10. The total amount of brightening agents used in the present compositions may vary over a wide range but is typically at least 0.01 mg/L, based on the bath. More typically, the total amount of brightening agents is at least 0.05 mg/L, still more typically at least 0.5 mg/L, and even more typically at least about 1 mg/L. For example, the brighteners may be present in an amount of from 0.01 mg/L to 200 mg/L. Particularly suitable amounts of brightener are at least 0.01 mg/L, and more particularly at least 4 g/L. Even higher brightener concentrations may be used, such as at least 10, 15, 20, 30, 40 or 50 mg/L, based on the bath. In one embodiment, a particularly useful range of such brightener concentrations is from 0.01 to 50 mg/L. In another embodiment, the dithicarbonate-containing brightener is present in an amount of 0.01 to 10 ppm and more typically from 1 to 10 ppm.

The present compositions may further include one or more other organic additives such as leveling agents and suppressor compounds. For example, although they are not necessary, one or more leveling agents may be used. Suitable leveling agents include, but are not limited to, one or more of nigrosines, pentamethyl-para-rosaniline hydrohalide, hexamethyl-para-rosaniline hydrohalide, reaction products of an amine with an epihalohydrin, or compounds containing a functional group of the formula N-R-S, where R is a substituted alkyl, unsubstituted alkyl, substituted aryl or unsubstituted aryl. Typically, the alkyl groups are (C₁-C₆)alkyl and preferably (C₁-C₄)alkyl. In general, the aryl groups include (C₆-C₂₀)aryl, preferably (C₆-C₁₀)aryl. Such aryl groups may further include heteroatoms, such as sulfur, nitrogen and oxygen. It is preferred that the aryl group is phenyl or napthyl. The compounds containing a functional group of the formula N-R-S are generally known, are generally commercially available and may be used without further purification.

In such above compounds containing the N-R-S functional group, the sulfur ("S") and/or the nitrogen ("N") may be attached to such compounds with single or double bonds. When the sulfur is attached to such compounds with a single bond, the sulfur will have another substituent group, such as but not limited to hydrogen, (C₁-C₁₂)alkyl, (C₂-C₁₂)alkenyl, (C₆-C₂₀)aryl, (C₁-C₁₂)alkylthio, (C₂-C₁₂)alkenylthio, (C₆-C₂₀)arylthio and the like. Likewise, the nitrogen will have one or more substituent groups, such as but not limited to hydrogen, (C₁-C₁₂)alkyl, (C₂-C₁₂)alkenyl, (C₇-C₁₀)aryl, and the like. The N-R-S functional group may be acyclic or cyclic. Compounds containing cyclic N-R-S functional groups include those having either the nitrogen or the sulfur or both the nitrogen and the sulfur within the ring system.

By "substituted alkyl" is meant that one or more of the hydrogens on the alkyl group is replaced with another substituent group, such as, but not limited to, cyano, hydroxy, halo, (C₁-C₆)alkoxy, (C₁-C₆)alkylthio, thiol, nitro, and the like. By "substituted aryl" is meant that one or more hydrogens on the aryl ring are replaced with one or more substituent groups, such as, but not limited to, cyano, hydroxy, halo, (C₁-C₆)alkoxy, (C₁-C₆)alkyl, (C₂-C₆)alkenyl, (C₁-C₆)alkylthio, thiol, nitro, and the like. "Aryl" includes carbocyclic and heterocyclic aromatic systems, such as, but not limited to, phenyl, naphthyl and the like.

When such leveling agents are used, they are typically used in an amount of from 0.5 ppm to 50 ppm based on the total weight of the plating bath, although greater amounts may be used. More typically, the total amount of leveling agent is from 1 to 25 ppm and even more typically from 2 to 20 ppm. In one embodiment, as the amount of leveling agent is increased in the plating bath that the amount of brightener is also increased. Amounts of leveling agent greater than about 1 ppm are particularly useful in certain plating baths.

Suitable suppressors are generally known in the art. It will be clear to one skilled in the art which suppressors to use and in what amounts. One of the advantages of the present invention is that such additional suppressors, while they might be beneficial in certain applications, are not required. Suppressors useful in the present invention include, but are not limited to, polymeric materials, particularly those having heteroatom substitution, and more particularly oxygen substitution. Typically the suppressor is a high molecular weight polyether, such as those of the formula:

R-O-(CXYCX'Y'O)ₙH

where R is H, (C₂-C₂₀)alkyl group or (C₆-C₁₀)aryl group; each of X, Y, X' and Y' is independently selected from hydrogen, alkyl such as methyl, ethyl or propyl, aryl such as phenyl, or aralkyl such as benzyl; and n is an integer from 5 to 100,000. It is preferred that one or more of X, Y, X' and Y' is hydrogen. In one embodiment, n is greater than 12,000. Particularly suitable suppressors include commercially available polyethylene glycol copolymers, including ethylene oxide-propylene oxide copolymers and butyl alcohol-ethylene oxide-propylene oxide copolymers. Suitable butyl alcohol-ethylene oxide-propylene oxide copolymers are those having a weight average molecular weight of 1800. When such suppressors are used, they are typically present in an amount in the range of from 1 to 10,000 ppm based on the weight of the bath, and more typically from 5 to 2,000 ppm.

It will be appreciated that a single dual-functioning organic additive may be used in the present plating baths. Such "dual-function" additives are capable of functioning as a leveling agent or a suppressor or as both a leveling agent and a suppressor in a copper plating bath. Dual-function additives (or compounds) of the invention typically contain a first moiety capable of providing a level copper deposit, a second moiety capable of suppressing copper plating and optionally a spacer group. The dual-functioning reaction products of the present invention may be used in a copper plating bath in any suitable amount. The particular amount used will depend upon the particular reaction product selected, the concentration of the copper and the acid in the plating bath and the current density used to deposit the copper, as well as whether a leveling function, a suppressing function or both functions is desired. In general, the dual-function compounds are used in a total amount of from 0.5 ppm to 10,000 ppm based on the total weight of the plating bath, although greater or lesser amounts may be used.

Particularly suitable compositions contain one or more sources of metal ions, electrolyte, water, two or more brightening agents, wherein at least one brightening agent is an organosulfonic acid compound and at least one brightening agent is a dithiocarbonate-containing compound, and one or more suppressors. In another embodiment, the composition further contains one or more suppressors and one or more leveling agents.

The compositions of the present invention can be prepared by combining one or more sources of metal ions, electrolyte, water, two or more brightening agents and any optional organic additives in any order. It is preferred that the inorganic components such as metal salts, water, acid and optional halide ion source, are first added to the bath vessel followed by the organic components such as leveling agents, brighteners, suppressors, surfactants and the like.

Typically, the plating baths of the present invention may be used at any temperature from 10° to 65° C or higher. More typically, the temperature of the plating baths is from 10° to 35° C and even more typically from 15° to 30° C.

In general, when the present invention is used to deposit metal on a substrate such as a wafer used in the manufacture of an integrated circuit, the plating baths are agitated during use. Any suitable agitation method may be used with the present invention and such methods are well-known in the art. Suitable agitation methods include, but are not limited to, air sparging, work piece agitation, impingement and the like.

When the present invention is used to plate an integrated circuit substrate, such as a wafer, the wafer may be rotated such as from 1 to 150 RPM and the plating bath contacts the rotating wafer, such as by pumping or spraying. In the alternative, the wafer need not be rotated where the flow of the plating bath is sufficient to provide the desired metal deposit.

Typically, substrates are electroplated by contacting the substrate with the plating baths of the present invention. The bath is typically subjected to a current density for a period of time sufficient to deposit a copper layer on the substrate. Suitable current densities, include, without limitation, the range of 1 to 100 mA/cm². Typically, the current densities are from 1 to 60 mA/cm². The specific current density depends upon the substrate to be plated, the plating bath composition selected and the like. Such current density choice is well within the skill of one in the art.

The present invention is useful for depositing a layer of metal, such as copper, on a variety of substrates, particularly those having variously sized apertures. Accordingly, the present invention provides a method of depositing copper on a substrate including the steps of: contacting a substrate to be plated with a metal, such as copper, with a metal plating bath composition described above; and then applying a current density for a period of time sufficient to deposit a copper layer on the substrate. For example, the present invention is particularly suitable for depositing copper on integrated circuit substrates, such as semiconductor devices, with one or more small diameter vias, trenches, or other apertures or any combinations of these. In one embodiment, it is preferred that semiconductor devices are plated according to the present invention. Such semiconductor devices include, but are not limited to, wafers used in the manufacture of integrated circuits.

In particular, the present invention provides a method for manufacturing an electronic device, such as an integrated circuit, including the steps of: contacting an electronic device substrate with a metal plating bath composition described above; and then applying a current density for a period of time sufficient to deposit a metal layer on the substrate. More particularly, the present invention provides a method for manufacturing an integrated circuit comprising the steps of: contacting an electronic device substrate with a copper plating bath; and then applying a current density for a period of time sufficient to deposit a copper layer on the substrate, wherein the copper plating bath includes 10 to 80 g/L as copper metal of one or more soluble copper salts, 5 to 250 g/L of one or more acids, 15 to 75 ppm of a halide ion, and 1 to 50 mg/L of two or more brighteners, wherein at least one brightening agent is an organosulfonic acid compound and at least one brightening agent is a dithiocarbonate-containing compound..

Copper is deposited in apertures without substantially forming voids according to the present methods. By the term "without substantially forming voids" it is meant that >95% of the plated features are void-free. Typically, >97% of the plated features are void-free and more typically the plated features are void-free.

An advantage of the present invention is that it provides metal deposits that are smoother, i.e. having less surface roughness, as measured by atomic force microscopy ("AFM"), as compared to conventional electroplating baths. By "smoother copper deposit" it is meant that the average surface roughness ("Ra") and the minimum to maximum height differential ("Z") of the copper deposit (as measured from an atomic force micrograph) having a certain thickness are lower than those achieved using conventional copper plating baths. For example, layers of copper deposited from the present plating baths typically have an arithmetic average roughness ("Ra") of ≤ 5 nm, and more typically ≤ 4 nm. For copper layers having a thickness of > 10,000 Å deposited from the present electroplating baths, suitable Ra values are ≤ 4 nm and more typically ≤ 3 nm. These copper layers also have a low Z-value, such as ≤ 100 nm. For copper layers having a thickness of 1000 Å, the value of Z is typically ≤ 90 nm and more typically ≤ 86 nm. For copper layers having a thickness of 10,000 Å, the value of Z is typically ≤ 50 nm and more typically ≤ 40 nm. The "Z-value" is the difference in heights in nm of the average of the 10 highest and 10 lowest points examined. The lower the Z-value, the more uniform the surface of the copper layer. It has been found that the present invention provides a smoother copper deposit during initial electroplating stages (i.e. ≤ 1000 - 2000 Å of deposit thickness), as well as during the later stages of plating (i.e. ≥ 10,000 Å of deposit thickness), as compared to conventional copper electroplating baths. It will be appreciated by those skilled in the art that deposit thicknesses formed during the middle stages of plating (i.e. approximately 2000 - 10,000 Å of deposit thickness) will also benefit from the present invention.

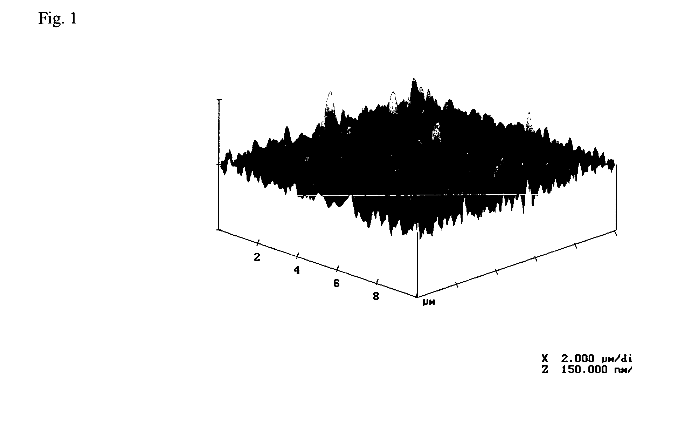

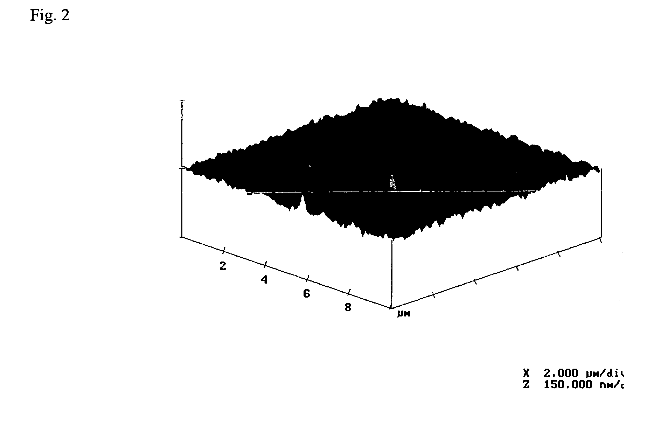

For example, Fig. 1 is an atomic force micrograph ("AFM") of a 1000 Å thick copper layer deposited using a conventional copper plating bath. Fig. 2 is an AFM of a 1000 Å thick copper layer deposited using a copper plating bath of the invention. These figures clearly show the present plating baths provide a metal deposit having a smoother surface that that obtained using conventional plating baths.

In another embodiment, the present invention provides a method of depositing a copper layer on a substrate having one or more apertures having a size of ≤ 2 µm, including the steps of contacting the substrate with an electroplating composition comprising one or more sources of metal ions, an electrolyte, and two or more brightening agents, and applying sufficient current density for a period of time to deposit the layer of copper, wherein the copper layer has an arithmetic surface roughness of ≤ 5 nm, as determined by atomic force microscopy.

A further advantage of the present invention is that smoother metal deposits are provided, which means less time and effort is spent in removing metal, such as copper, during subsequent chemical-mechanical polishing ("CMP") process, particularly copper removal during integrated circuit manufacture. A further advantage of the present invention is that a wide range of apertures sizes may be filled within a single substrate with substantially no suppressed local plating. Thus, the present invention is particularly suitable to substantially filling apertures in a substrate having a variety of aperture sizes, such as from 0.18 µm to 100 µm.

While the process of the present invention has been generally described with reference to semiconductor manufacture, it will be appreciated that the present invention may be useful in any electrolytic process where an essentially level or planar metal deposit such as a layer of copper having high reflectivity is desired, and where reduced overplating and metal filled small apertures that are substantially free of voids are desired. Such processes include printed wiring board manufacture, advanced packaging, micro-electrical-mechanical devices, and the like. For example, the present plating baths may be useful for the plating of vias, pads or traces on a printed wiring board, as well as for bump plating on wafers. Other suitable processes include packaging and interconnect manufacture. Accordingly, suitable substrates include lead frames, interconnects, printed wiring boards, and the like.

Thus, electronic devices such as semiconductor devices, semiconductor packages, printed circuit boards and the like, are formed according to the present invention having substantially planar copper layers and filled features that are substantially free of added defects, wherein the copper layer has not been subjected to polishing processes, such as a CMP process, electropolishing or silmultaneous plating and planarization techniques. By "substantially planar copper layer" is meant that the step height difference between areas of dense very small features and areas free of or substantially free of dense very small features is less than 1 µm, preferably less than 0.5 µm, more preferably less than 0.2 µm, and even more preferably less than 0.1 µm. "Substantially free of added defects" refers to the leveling agent not increasing the number or size of defects, such as voids, in very small features as compared to control plating baths not containing such leveling agent. A further advantage of the present invention is that a substantially planar metal layer may be deposited on a substrate having non-uniformly sized small features, wherein the features are substantially free of added voids, with the use of a single leveling agent. "Non-uniformly sized small features" refer to small features having a variety of sizes in the same substrate. Thus, the need to tailor the leveling agent to the size of the feature to be filled is avoided.

The following examples are intended to illustrate further various aspects of the present invention, but are not intended to limit the scope of the invention in any aspect.

### Example 1

Two copper plating baths are prepared by combining 40 g/L copper as copper sulfate, 10 g/L sulfuric acid, 20 ppm chloride ion, 175 ppm of an ethylene oxide-propylene oxide copolymer having a molecular weight of approximately 2500 as suppressor, 2 ppm of an imidazole-epihalohydrin reaction product as leveling agent, 12 ppm of bis-(sodium sulfopropyl)-disulfide as brightener and water to 1L. Nothing else is added to the first copper plating bath (Comparative). To the second plating bath (Inventive) is added 4.8 ppm of (O-ethyldithiocarbonato)-S-(3-sulfopropyl)-ester, potassium salt as a second brightener.

Layers of copper are electroplated onto wafer substrates by contacting a spinning wafer segment (4 cm x 4 cm) at 200 RPM with one of the above plating baths at 25° C. A current density ramp of 10 mA/cm2 (for 0-1000 Å of deposit thickness), 20 mA/cm2 (1000-2000 Å), 30 mA/cm2 (2000-3000 Å), 40 mA/cm2 (3000-4000 Å), 50 mA/cm2 (4000-5000 Å), and 60 mA/cm2 (5000-10,000 Å), is applied and a copper layer is deposited on each wafer to a thickness of either 0.1 µm or 1 µm. The layers of copper are analyzed by AFM to determine the arithmetic average roughness ("Ra") and height differential ("Z"). Fig. 1 shows the AFM of the 0.1 µm (1000 Å) thick copper deposit obtained from the Comparative plating bath. Fig. 2 shows the AFM of the 0.1 µm (1000 Å) thick copper deposit obtained from the Inventive plating bath. These results are reported in Table 1.

**Table 1**

| Plating Bath | Copper Thickness (Å) | Ra (nm) | Z (nm) |
|---|---|---|---|
| Comparative | 1000 | 8.91 | 141 |
| " | 10,000 | 4.33 | 66.3 |
| Inventive | 1000 | 3.4 | 85.8 |
| " | 10,000 | 2.82 | 34.6 |

The lower the value of Ra is, the smoother the surface is. Lower values of Z indicate a more uniform surface height across the evaluated area. Thus, layers of copper having low Ra and Z-values are desired. As can be seen from the above data, the copper layers deposited from the bath of the invention show a 50% reduction in average surface roughness as compared to the copper layers deposited from the Comparative plating bath. For a given thickness of metal deposit the present plating baths provide smoother surfaces than those obtained from conventional copper baths.

### Example 2

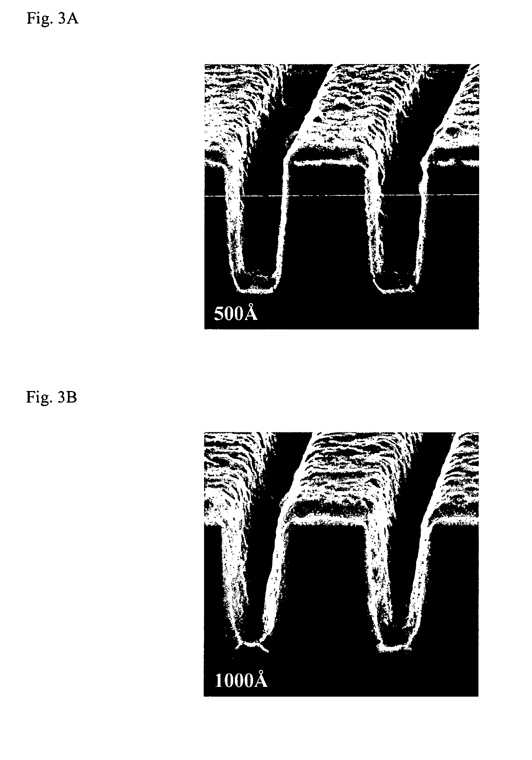

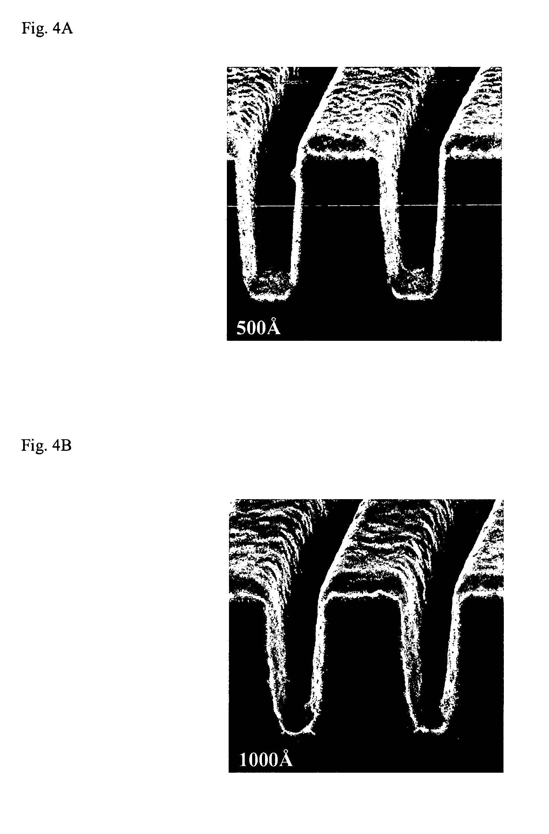

The procedure of Example 1 is repeated except that the wafer substrates have 0.5 µm trenches. The wafers are plated for a time sufficient to deposit either a 500 Å or 1000 Å thick copper layer. After plating, the wafers are cross-sectioned and analyzed by scanning electron microscopy. Figs. 3A and 3B are scanning electron micrographs ("SEMs") of a cross-section of a 0.5 µm trench on a wafer plated with a 500 Å and 1000 Å, respectively, thick copper layer using the Comparative copper plating bath. Figs. 4A and 4B are SEMs of a cross-section of a 0.5 µm trench on a wafer plated with a 500 Å and 1000 Å, respectively, thick copper layer using the Inventive copper plating bath. These data clearly show that the copper layer deposited from the Inventive plating bath has less surface roughness that that obtained from the Conventional copper plating bath.

### Examples 3-11

The procedure of Example 1 is repeated except that a dithiocarbonate-containing brightener of the following formula is used instead of (O-ethyldithiocarbonato)-S-(3-sulfopropyl)-ester, potassium salt:

R-O-C(=S)-S-R¹-SO₃X

| Example | R | R¹ | X |
|---|---|---|---|
| 3 | Ethyl | Propyl | Sodium |
| 4 | Ethyl | Propyl | Hydrogen |
| 5 | Methyl | Propyl | Potassium |
| 6 | Methyl | Ethyl | Potassium |
| 7 | Ethyl | Ethyl | Hydrogen |
| 8 | Propyl | Propyl | Potassium |
| 9 | Ethyl | Butyl | Hydrogen |
| 10 | Ethyl | Butyl | Potassium |
| 11 | Methyl | Butyl | Sodium |

## Claims

1. A composition comprising one or more sources of metal ions, an electrolyte, and two or more brightening agents, wherein at least one brightening agent is an organosulfonic acid compound and at least one brightening agent is a dithiocarbonate-containing compound.

2. The composition of claim 1 wherein the metal is copper.

3. The composition of any one of claims 1 or 2 further comprising one or more organic additives selected from leveling agents and suppressor agents.

4. The composition of any one of claims 1 to 3 wherein the organosulfonic acid compound and the dithiocarbonate-containing compound are present in a weight ratio of ≥3:1.

5. The composition of any one of claims 1 to 3 wherein the organosulfonic acid compound and the dithiocarbonate-containing compound are present in a ratio of 20:1 to 1:20.

6. A method of depositing a metal layer on a substrate comprising the steps of contacting the substrate with the composition of any one of claims 1 to 5 and applying sufficient current density for a period of time to deposit the layer of metal.

7. A method of manufacturing an electronic device comprising the step of depositing a layer of metal on the substrate by contacting the substrate with the composition of any one of claims 1 to 5 and applying sufficient current density for a period of time to deposit the layer of metal.

8. The method of any one of claims 6 or 7 wherein the substrate has one or more apertures having a size of ≤ 2 µm.

9. A method of depositing a copper layer on a substrate having one or more apertures having a size of ≤ 2 µm, comprising the steps of contacting the substrate with an electroplating composition comprising one or more sources of metal ions, an electrolyte, and two or more brightening agents, and applying sufficient current density for a period of time to deposit the layer of copper, wherein the copper layer has an arithmetic surface roughness of ≤ 5nm, as determined by atomic force microscopy.

10. The method of claim 17 wherein at least one brightening agent is an organosulfonic acid compound and at least one brightening agent is a dithiocarbonate-containing compound.
